Europäisches Patentamt

European Patent Office

Office européen des brevets

(19)

(11) **EP 1 071 250 B1**

(12) **FASCICULE DE BREVET EUROPEEN**

(45) Date de publication et mention
de la délivrance du brevet:
**20.07.2005 Bulletin 2005/29**

(51) Int Cl.$^7$: **H04L 27/20**, H03C 3/09,
H03L 7/197, H04B 1/40

(21) Numéro de dépôt: **00402062.4**

(22) Date de dépôt: **20.07.2000**

(54) **Dispositif d'émission radioélectrique**

Funksender

RF transmission device

(84) Etats contractants désignés:
**AT BE CH CY DE DK ES FI FR GB GR IE IT LI LU
MC NL PT SE**

(30) Priorité: **22.07.1999 FR 9909536**

(43) Date de publication de la demande:
**24.01.2001 Bulletin 2001/04**

(73) Titulaire: **ALCATEL**
**75008 Paris (FR)**

(72) Inventeurs:
• **Savelli, Patrick**
**75012 Paris (FR)**

• **Nikolopoulou, Vassiliki**
**75019 Paris (FR)**

(74) Mandataire: **Korakis-Ménager, Sophie et al**
**COMPAGNIE FINANCIERE ALCATEL**
**Département Propriété Industrielle**
**54, rue La Boétie**
**75008 Paris (FR)**

(56) Documents cités:
**EP-A- 0 125 811      EP-A- 0 408 238**
**US-A- 5 055 802      US-A- 5 111 162**
**US-A- 5 128 633**

## Description

La présente invention a pour objet un dispositif d'émission radioélectrique principalement utilisable dans le domaine de la téléphonie mobile. D'autres utilisations sont toutefois envisageables. Le but de l'invention est de réduire le prix des équipements par le biais d'une simplification de leur constitution.

Le document US-A-5 128 633 décrit un dispositif avec une combinaison de plusieurs boucles de réglage ayant chacune un diviseur de fréquence et dont une boucle comporte un modulateur.

Il est connu, pour réaliser un téléphone mobile notamment, d'agencer des circuits d'émission et de réception radioélectrique à partir d'un jeu, commun, d'oscillateurs locaux. On connaît ainsi d'une manière habituelle des montages à deux ou trois oscillateurs locaux. Par exemple, un signal à une fréquence intermédiaire, par exemple de l'ordre de 100 MHz et produit par un premier oscillateur local intermédiaire, est comparé à un signal produit par un oscillateur local de transition. La comparaison est une comparaison de phase, et l'un ou l'autre, voire les deux signaux, subissent des divisions de leur fréquence avant la comparaison de phase.

Le signal issu du comparateur de phase sert à commander en tension un troisième oscillateur servant d'oscillateur d'émission. Alors que les oscillateurs locaux à fréquence intermédiaire et à fréquence de transition produisent de préférence pour l'un des signaux à fréquence fixe et pour l'autre des signaux à fréquence variable, l'oscillateur local commandé en tension produit un signal dont la fréquence varie en fonction du signal de comparaison. Cette variation est mise à profit dans le domaine de la téléphone mobile pour organiser une agilité de fréquence et prévoir, d'une trame d'émission ou de réception à une trame suivante, un saut de fréquence d'un canal de transmission. Pour fixer les idées, dans le domaine du GSM à 900 MHz ainsi que dans le domaine du DCS à 1800 MHz, les canaux retenus ont une largeur de 200 KHz. Les divisions de fréquence des signaux de boucle et à fréquence intermédiaire permettent une agilité en fréquence du dispositif.

Un tel montage classique présente plusieurs particularités. D'une part, la nécessité de réaliser des téléphones mobiles dit bibandes, c'est à dire capable de fonctionner à la fois dans la gamme GSM 900 MHz et dans la gamme DCS 1800 MHz peut imposer de doubler le nombre des oscillateurs locaux. De ce fait, sans précautions, on pourrait être conduit à des montages avec six oscillateurs locaux. Le coût de tels équipements serait alors excessif. En outre, le principe de la régulation du troisième oscillateur local par un signal issu d'un comparateur de phase nécessite la présence d'un filtre de boucle pour que la régulation soit stable et non pas divergente. Alors que la boucle possède un tel filtre, placé naturellement entre le comparateur de phase et l'oscillateur commandé en tension, elle possède par ailleurs des caractéristiques de filtrage réparties lui donnant une fonction de transfert passe-bas avec une fréquence de coupure un peu différente de la fréquence de coupure du filtre, tout en étant du même ordre.

Le choix de cette fréquence de coupure de boucle est un paramètre important. En effet plus elle est basse, plus la boucle sera stable mais, par opposition, moins elle sera susceptible de basculer rapidement au moment des sauts de fréquence nécessités par l'agilité de fréquence. En outre, si on souhaite moduler le signal avant son entrée dans la boucle, cela n'est possible que si le filtre n'est pas trop étroit pour laisser passer la modulation GMSK. Un compromis est donc nécessaire. En outre la présence dans la boucle d'un mélangeur combinant les signaux du troisième oscillateur local avec ceux du deuxième oscillateur local induit des bruits de mélange qui se transmettent dans la boucle et qui retentissent en une émission d'un signal issu du troisième oscillateur local qui est bruité. Le bruit proche de la fréquence de porteuse est filtré par la boucle mais pas les harmoniques. Par ailleurs le filtre amortit les composants harmoniques de la fréquence de comparaison du comparateur de phase. Il y a donc un compromis à trouver pour le filtre. Ce compromis est équivalent à une ouverture de bande de boucle pour commuter plus vite et à une fermeture de bande de boucle pour supprimer ces composantes de bruit.

Bien entendu, un tel émetteur n'émet pas qu'un signal de porteuse. Il est destiné à émettre un signal de porteuse modulée par un signal de modulation. Plusieurs solutions sont envisageables pour introduire le signal de modulation en modulation du signal de porteuse émis.

La première solution restante consiste à moduler par le signal de modulation le signal à fréquence intermédiaire, avant son injection dans le comparateur de phase. L'inconvénient de cette solution est qu'elle engendre un nombre important d'oscillateurs locaux. Les oscillateurs locaux ne pouvant pas être intégrés sur un circuit intégré comportant le dispositif d'émission, ils en compliquent la construction et ils en augmentent l'encombrement. Par ailleurs les oscillateurs locaux sont des circuits assez onéreux.

Dans une autre solution restante, la modulation de la porteuse est réalisée dans la boucle de régulation. Dans ce cas, entre le troisième oscillateur local d'émission et le deuxième oscillateur à fréquence de transition, on place un modulateur. Un tel modulateur comporte dans son principe un mélangeur réalisé à base d'un circuit non linéaire. En dehors de la modulation qu'ils produisent, ces circuits non linéaires ont l'inconvénient de produire beaucoup de bruit. En outre, le besoin d'ouvrir la boucle pour faire passer la modulation fait qu'on filtre moins le bruit et qu'on augmente l'erreur de phase de l'émetteur. Ce bruit est encore augmenté par la présence des diviseurs nécessaires pour l'agilité en fréquence. Les bruits produits sont d'autant plus forts que les coefficients de division dans la boucle sont importants. On connaît ainsi des diviseurs par 9000 ou par 4500 pour produire des signaux avec des fréquences de l'ordre de 200 KHz, comparables à un signal à fréquence intermédiaire.

Dans l'invention on a voulu résoudre ce problème de bruit en même temps que réduire le nombre d'oscillateurs locaux nécessaires. On obtient ces deux effets simultanément simplement en plaçant dans la boucle, en lieu et place des mélangeurs ou des diviseurs avec coefficients importants qui permettent d'abaisser la fréquence, des diviseurs fractionnaires qui permettent alors de comparer, dans le comparateur, un premier signal dont la fréquence a été ainsi divisée à un deuxième signal à une fréquence intermédiaire, de préférence avec une fréquence plus élevée que dans l'état de la technique. Il en résulte, dans un cas particulièrement judicieux, l'utilisation d'un seul oscillateur local, l'oscillateur à fréquence intermédiaire étant tout simplement constitué par une horloge très stable, en particulier à 13 MHz, déjà disponible dans un circuit intégré plus général qui comporte notamment le dispositif d'émission.

Deuxièmement du fait d'une modulation directe du signal d'émission dans la boucle de régulation avant la division en fréquence, la solution de l'invention n'impose pas de requérir une division d'indice de modulation. Une telle division entraînerait au préalable une amplification du signal de modulation. Ce qui induit automatiquement une baisse de la résolution de la partie numérique du système, et donc entraîne des simplifications dans les circuits de traitement et dans les circuits logiques de commande.

En outre, on pourra montrer qu'un tel diviseur fractionnaire ne produit qu'un bruit lié à la partie entière de la division. Ce bruit est donc notablement inférieur au bruit produit par des diviseurs avec fort coefficient. Le rapport sera environ de 1 à 30. De ce fait, la présence du filtre passe-bas, à environ 200 KHz présent dans la boucle sera suffisant pour éliminer les bruits résiduels et permettra de satisfaire les contraintes des normes. De ce fait, l'ouverture de la bande de boucle ne se réalisera pas au détriment des performances de bruit (pas d'augmentation d'erreur de phase). Avec le synthétiseur de l'invention, on peut garder une largeur de bande de boucle plus grande ce qui est favorable car procurant une vitesse de saut, ou de commutation, plus grande au moment des sauts de fréquence nécessités par l'agilité en fréquence.

L'invention a donc pour objet un dispositif d'émission radioélectrique comportant dans une boucle de régulation de phase un oscillateur commandé en tension produisant un signal à émettre, un modulateur pour moduler ce signal à émettre par un signal de modulation et produire un signal modulé, et un comparateur de phase recevant sur une première entrée un signal représentatif du signal modulé et sur une deuxième entrée un signal de référence à une fréquence intermédiaire, caractérisé en ce que la boucle de régulation comporte un diviseur de fréquence fractionnaire interposé entre le modulateur et le comparateur.

L'invention sera mieux comprise à la lecture de la description qui suit et à l'examen de la figure qui l'accompagne. Celles-ci ne sont présentées qu'à titre indicatif et nullement limitatif de l'invention.

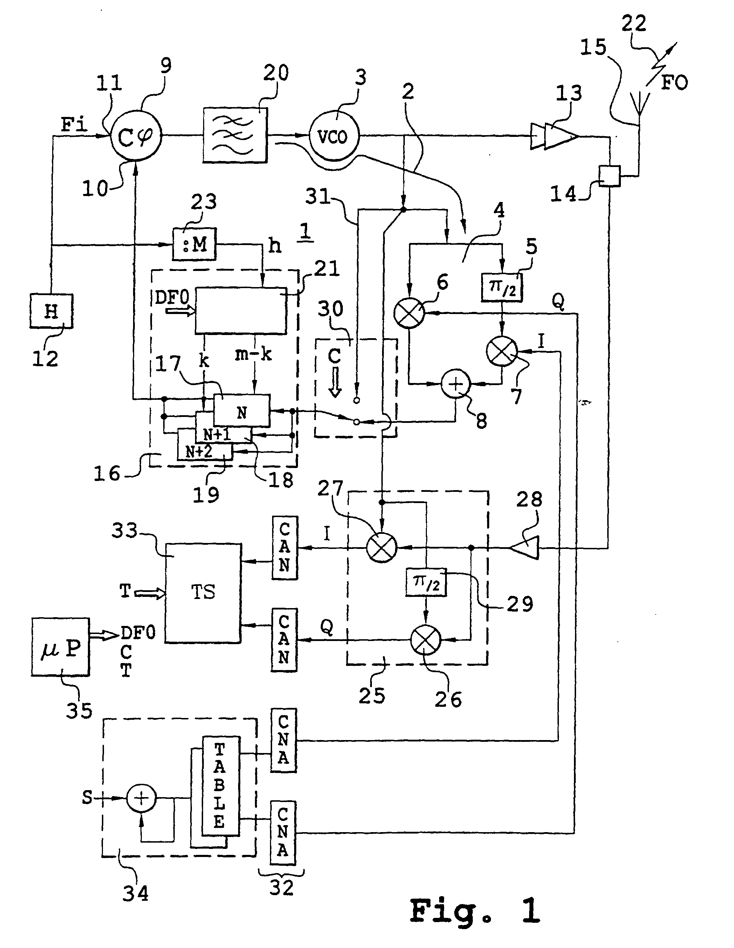

La figure 1 montre un dispositif d'émission radioélectrique conforme à l'invention.

La figure 1 montre un dispositif 1 d'émission radioélectrique. Ce dispositif comporte une boucle 2 de régulation. La boucle 2 comporte essentiellement un oscillateur 3 commandé en tension. A titre d'exemple, l'oscillateur 3 sera par exemple un oscillateur susceptible de produire un signal de l'ordre de 1800 MHz pour convenir à une émission selon la norme DCS. Toutefois, on peut envisager des oscillateurs dont la plage de fréquences sera de préférence telle qu'il pourrait émettre dans la gamme 900 MHz (correspondant à la norme GSM), 1900 MHz (correspondant à la norme PCS), voire à des fréquences supérieures, c'est à dire à 2200 MHz correspondant à la norme UMTS. La boucle 2 comporte également un modulateur 4. Le modulateur 4 sert à moduler, en émission, le signal produit par l'oscillateur 3.

Dans ce but d'une manière classique le modulateur 4 comporte un premier déphaseur 5 par π/2 de manière à disposer du signal de cet oscillateur et de ce signal déphasé de π/2. Les deux signaux ainsi disponibles sont appliqués sur des premières entrées de deux mélangeurs respectivement 6 et 7 qui reçoivent chacun sur leurs deuxièmes entrées des signaux de modulation dits I et Q, connus dans l'état de la technique. Les sorties des mélangeurs 6 et 7 sont reliées aux deux entrées d'un additionneur 8 produisant le signal de l'oscillateur 3 modulé par les signaux I et Q. Une sortie de l'additionneur 8 est reliée à un comparateur de phase 9.

Le comparateur 9 reçoit sur une première entrée 10 le signal issu de l'additionneur 8, et sur une deuxième entrée 11 un signal de référence produit par un générateur 12 à une fréquence intermédiaire. D'une manière préférée, comme on le verra plus loin le générateur 12 est une horloge, à 13 MHz dans un exemple, très stable d'un circuit intégré dans lequel est réalisé le dispositif d'émission présenté, et qui sert par ailleurs à cadencer le fonctionnement d'un circuit de traitement général. De ce fait, un tel oscillateur local pour le générateur 12 n'aura pas lieu d'être particulièrement réalisé.

Pour que le circuit 1 soit un circuit d'émission il est par ailleurs relié d'une manière classique en sortie de l'oscillateur 3 à un amplificateur de puissance 13 relié en sortie par l'intermédiaire d'un diplexeur 14, c'est-à-dire un simple commutateur émission/réception à un aérien d'émission 15.

Selon une particularité essentielle de l'invention, on interpose entre le modulateur 4 et le comparateur 9 un diviseur de fréquence fractionnaire 16. Schématiquement ce diviseur fractionnaire 16 comporte, dans un exemple, un jeu de diviseurs élémentaires 17, 18 voire 19 qui sont susceptibles de multiplier le signal issu de l'additionneur 8 respectivement par une fraction entière de coefficient N, ou par une autre fraction entière de coefficient différent N+1, voire N+2 ou autre. On peut montrer que si, pendant une certaine durée, on provoque une division du signal issu du modulateur 4 par un coefficient N et, pendant une autre durée par un coefficient N+1 on obtiendra un signal dont la fréquence moyenne sera intermédiaire entre celles résultant de ces deux divisions entières. On aura donc effectué une division fractionnaire. De façon à ce que la fréquence instantanée produite soit égale à cette fréquence moyenne, on s'arrange pour que la périodicité des commutations soit assez courte. En pratique la fréquence de ces commutations sera supérieure à la fréquence de coupure passe-bas de la boucle 2, qui est du même ordre que la fréquence de coupure passe-bas d'un filtre passe-bas 20 interposé entre le comparateur 9 et l'oscillateur 3. Ces commutations sont organisées par un circuit de commande 21 qui reçoit d'une part une information DF0 de données relatives à une fréquence F0 d'un signal 22 radioélectrique émis par l'antenne 15 et d'autre part un signal de cadencement h. Le signal de cadencement h peut être dérivé du générateur 12 par l'intermédiaire d'un diviseur 23 par M, par exemple un diviseur par cinq ou dix. La fréquence du signal h est intermédiaire entre la fréquence du signal de l'horloge 12 et la fréquence de coupure de la boucle 2 et donc du filtre 20.

On va donner ci-après un exemple chiffré du fonctionnement du diviseur fractionnaire 16 pour simplifier l'explication. A partir d'un signal à 1800 MHz produit par l'oscillateur 3, il faut produire avec le diviseur fractionnaire 16 des signaux à 13 MHz comparables à ceux produits par l'horloge 12. Cette division conduit à un coefficient valant 138 plus des parties décimales. Par ailleurs il faut organiser, conformément aux exigences de la norme, des sauts de fréquence de 200 KHz pour permettre l'agilité en fréquence de l'oscillateur 3. Partant d'un signal de comparaison à 13 MHz, on obtient une bande de 200 KHz en divisant 13 MHz par 65. Dans ces conditions le diviseur fractionnaire devra être capable d'effectuer une division par un coefficient valant 138 + k/65. On peut écrire ce coefficient de la manière suivante :

$$138 + \frac{k}{65} =$$

$$138 + \frac{k*139 - k*138}{65} =$$

$$\frac{65*138}{65} + \frac{k*139}{65} - \frac{k*138}{65} =$$

$$\frac{(65-k)*138 + k*139}{65} =$$

Ce qui peut encore s'écrire

$$\frac{(n-k)*N + k*(N+1)}{n} =$$

Dans cette dernière formule n représente le coefficient par lequel il faut diviser la valeur de la fréquence intermédiaire Fi produite par le générateur d'horloge 12 pour obtenir la largeur de canal désirée pour les incréments de sauts en fréquence, soit dans le cas présent 200 KHz à partir de 13 MHz. Dans cette formule, N désigne la partie entière du rapport de la fréquence F0 à produire à la fréquence intermédiaire Fi. En pratique, le circuit de commande 21 met en service un diviseur élémentaire, par exemple le diviseur élémentaire 17 par N dans la boucle pendant une durée k, alors que pendant une durée m-k un autre diviseur élémentaire est mis en service. En fait, un même diviseur peut être employé avec des coefficients de division valant N, N+1, N+2. La période m est l'inverse de la fréquence du signal h. Eventuellement, si les sauts en fréquence doivent s'étendre au-delà d'une partie entière de la fréquence du signal d'horloge 12, le diviseur élémentaire par 139, N+1, peut être remplacé par un diviseur élémentaire par 140, N+2, voire N+l avec l entier.

Pour simplifier l'explication du fonctionnement du circuit 21, on peut imaginer qu'on compte k fois la sollicitation du diviseur 18 pour m - k fois la sollicitation du diviseur 17 et ainsi de suite au rythme des oscillations du signal h. D'autres réalisations sont possibles dans lesquelles sur m sollicitations, les k sollicitations du diviseur 18 sont entrelacées avec les m - k sollicitations du diviseur 17. Du fait de la présence du filtrage de boucle, notamment du filtre 20, la fréquence F0 fractionnaire est ralliée par l'oscillateur 3 à laquelle ce dernier se stabilise. Un avantage de cette division fractionnaire est que le bruit produit est soit le bruit lié au diviseur 1, soit le bruit lié au diviseur 18 : dans tous les cas un bruit faible. Un autre avantage est qu'avec une fréquence Fi élevée, le ralliement est plus rapide. De ce fait le filtre 20 peut avoir une fréquence de coupure plus grande, par exemple plus grande que 200 KHz.

Par ailleurs le montage préconisé dans l'invention permet d'utiliser l'unique oscillateur commandé en tension 3 comme unique oscillateur d'un circuit de réception. Un tel circuit de réception comporte alors un démodulateur 25 dont des mélangeurs 26 et 27 reçoivent sur leurs premières entrées un signal radioélectrique reçu par l'antenne 15, sélectionné par le diplexeur 14, et préamplifié par un préamplificateur 28 à faible bruit. Sur leurs deuxièmes entrées les mélangeurs 26 et 27 reçoivent le signal produit par l'oscillateur local 3, ou par ce signal déphasé de $\pi/2$ dans un déphaseur 29.

Dans ce cas, on peut prévoir qu'un commutateur 30 permette de mettre en service dans la boucle de régulation de l'oscillateur 3 soit le modulateur 4, comme envisagé jusqu'ici, soit une connexion de court circuit 31. Une autre façon de faire consiste également à utiliser le modulateur 4 mais à transmettre sur les signaux I et Q des valeurs constantes, par exemple Q=0 et I=0. En agissant ainsi la boucle 1 émet un signal stable à la fréquence pure non modulée F0. Dans ce cas, le commutateur 30 peut être omis.

Les modulateurs 4 et 25 sont en relation avec des circuits 32 de conversion numérique analogique et analogique numérique respectivement. Ces circuits aboutissent d'une manière connue dans des circuits 33 de traitement de signal en réception, ou 34 d'accumulation de phase de type connu en émission. Tous ces circuits sont commandés par un microprocesseur 35, représenté ici symboliquement, comportant par ailleurs une mémoire programme. Le microprocesseur 35 est capable de produire, sur un bus de commande, les ordres DF0 de commande du circuit 21, des ordres C de commutation d'utilisation d'émission en réception, ou réciproquement. Les ordres C sont à appliquer sur le commutateur 30. Le microprocesseur 35 produit aussi des ordres T de traitement correspondant au réglage du dispositif d'émission pour souscrire aux exigences de sauts en fréquence et de synchronisation, notamment dans le cadre de la téléphonie mobile.

**Revendications**

1. Dispositif d'émission (1) radioélectrique comportant dans une boucle (2) de régulation de phase un oscillateur (3) commandé en tension produisant un signal (22) à émettre, un modulateur (4) pour moduler ce signal à émettre par un signal de modulation (I, Q) et produire un signal modulé, et un comparateur (9) de phase recevant sur une première entrée (10) un signal représentatif du signal modulé et sur une deuxième entrée (11) un signal de référence à une fréquence intermédiaire (Fi), **caractérisé en ce que** la boucle (2) de régulation comporte un diviseur (16) de fréquence fractionnaire interposé entre le modulateur (4) et le comparateur (19).

2. Dispositif selon la revendication 1, **caractérisé en ce que** la boucle de régulation comporte un commutateur (30) interconnecté entre le modulateur et le diviseur de fréquence fractionnaire et entre l'oscillateur et le diviseur de fréquence fractionnaire.

3. Dispositif selon la revendication 1 ou 2, **caractérisé en ce qu'**il comporte dans le diviseur de fréquence fractionnaire un jeu de diviseurs (17-19) élémentaires de fréquence par des nombres entiers (N, N+1) et un circuit (21) pour mettre ces diviseurs élémentaires en service à tour de rôle (k, m-k).

4. Dispositif selon la revendication 3, **caractérisé en ce que** les diviseurs élémentaires (17-19) ont des coefficients de division différents par une unité.

5. Dispositif selon l'une des revendications 3 à 4, **caractérisé en ce que** le circuit (21) de mise en service met en service tour à tour les diviseurs élémentaires à un rythme (h) intermédiaire entre la fréquence intermédiaire (Fi) et la fréquence de coupure d'un filtre passe-bas (20) interposé entre le comparateur (9) et l'oscillateur (3).

6. Dispositif selon la revendication 5, **caractérisé en ce que** le filtre passe-bas (20) a une fréquence de coupure plus haute que 200 KHz.

7. Dispositif selon l'une des revendications 1 à 6, **caractérisé en ce que** la fréquence du signal de référence (Fi) est de 13 MHz.

8. Dispositif selon l'une des revendications 1 à 7, **caractérisé en ce qu'**il comporte un récepteur et un unique oscillateur commandé en tension utilisé alternativement en émission et en réception.

**Claims**

1. A radio transmission system (1) including, in a phase control loop (2), a voltage-controlled oscillator (3) producing a signal (22) to be transmitted, a modulator (4) modulating the signal to be transmitted by a modulation signal (I, Q) to produce a modulated signal, and a phase comparator (9) receiving on a phase input (10) a signal representative of the modulated signal and on a second input (11) a reference signal at an intermediate frequency (Fi), **characterized in that** the control loop (2) includes a fractional frequency divider (16) between the modulator (4) and the comparator (9).

2. A system according to claim 1, **characterized in that** the control loop includes a switch (30) for selectively connecting the modulator or the oscillator to the fractional frequency divider.

3. A system according to claim 1 or claim 2, **characterized in that** the fractional frequency divider includes a set of frequency divider units (17-19) dividing by integer numbers (N, N+1) and a selector circuit (21) for selecting the frequency divider units in turn (k, m - k).

4. A system according to claim 3, **characterized in that** the divider units (17-19) have division coefficients which differ by one unit.

5. A system according to claim 3 or claim 4, **characterized in that** the selector circuit (21) selects the frequency divider units in turn at a clock frequency (h) between the intermediate frequency (Fi) and the cut-off frequency of a low-pass filter (20) between the comparator (9) and the oscillator (3).

6. A system according to claim 5, **characterized in that** the low-pass filter (20) has a cut-off frequency higher than 200 kHz.

7. A system according to any of claims 1 to 6, **characterized in that** the frequency (Fi) of the reference signal is 13 MHz.

8. A system according to any of claims 1 to 7, **characterized in that** it includes a receiver and a single voltage-controlled oscillator which is used alternately to transmit and to receive.

**Patentansprüche**

1. Funksender (1), welcher in einer Phasenregelungsschleife (2) einen spannungsgesteuerten Oszillator (3) umfasst, der ein zu sendendes Signal (22) erzeugt, einen Modulator (4), um dieses zu sendende Signal durch ein Modulationssignal (I, Q) zu modulieren und ein moduliertes Signal zu erzeugen, und einen Phasenkomparator (9), der an einem ersten Eingang (10) ein für das modulierte Signal repräsentatives Signal empfängt und an einem zweiten Eingang (11) ein Bezugssignal mit einer Zwischenfrequenz (Fi), **dadurch gekennzeichnet, dass** die Regelungsschleife (2) einen Frequenz-Bruchteiler (16) umfasst, der zwischen dem Modulator (4) und dem Komparator (9) angeordnet ist.

2. Vorrichtung nach Anspruch 1, **dadurch gekennzeichnet, dass** die Regelungsschleife einen Umschalter (30) umfasst, der zwischen dem Modulator und dem Frequenz-Bruchteiler sowie zwischen dem Oszillator und dem Frequenz-Bruchteiler verbunden ist.

3. Vorrichtung nach Anspruch 1 oder 2, **dadurch gekennzeichnet, dass** er in dem Frequenz-Bruchteiler einen Satz von Frequenz-Elementarteilem (17 - 19) durch ganze Zahlen (N, N+1) aufweist sowie eine Schaltung (21), um diese Elementarteiler der Reihe nach (k, m-k) in Betrieb zu nehmen.

4. Vorrichtung nach Anspruch 3, **dadurch gekennzeichnet, dass** die Elementarteiler (17 - 19) Teilungskoeffizienten aufweisen, die sich jeweils um einen Einerschritt unterscheiden.

5. Vorrichtung nach einem der Ansprüche 3 bis 4, **dadurch gekennzeichnet, dass** die Inbetriebnahmeschaltung (21) reihum die Elementarteiler in einem Rhythmus (h) in Betrieb nimmt, der zwischen der Zwischenfrequenz (Fi) und der Grenzfrequenz eines Tiefpassfilters (20) liegt, das zwischen dem Komparator (9) und dem Oszillator (3) angeordnet ist.

6. Vorrichtung nach Anspruch 5, **dadurch gekennzeichnet, dass** das Tiefpassfilter (20) eine höhere Grenzfrequenz als 200 kHz hat.

7. Vorrichtung nach einem der Ansprüche 1 bis 6, **dadurch gekennzeichnet, dass** die Frequenz des Bezugssignals (Fi) 13 MHz beträgt.

8. Vorrichtung nach einem der Ansprüche 1 bis 7, **dadurch gekennzeichnet, dass** sie einen Empfänger und einen einzigen spannungsgesteuerten Oszillator aufweist, der abwechselnd zum Senden und zum Empfangen genutzt wird.

**Fig. 1**